# EUROPEAN PATENT SPECIFICATION

(11) **EP 3 276 698 B1**
(45) Date of publication and mention of the grant of the patent: **22.07.2020**
(21) Application number: 17182739.7
(22) Date of filing: 24.07.2017
(51) Int. Cl.: H01L 51/50

(54) **ORGANIC LIGHT EMITTING DEVICE AND ORGANIC LIGHT EMITTING DISPLAY USING THE SAME**
ORGANISCHE LICHTEMITTIERENDE VORRICHTUNG UND ORGANISCHE LICHTEMITTIERENDE ANZEIGE DAMIT
DIODE ÉLECTROLUMINESCENTE ORGANIQUE ET DISPOSITIF D'AFFICHAGE ÉLECTROLUMINESCENT ORGANIQUE L'UTILISANT

(30) Priority: 29.07.2016 KR 20160097549
(43) Date of publication of application: 31.01.2018
(73) Proprietor: LG Display Co., Ltd., Seoul 150-721 (KR)
(72) Inventor: KIM, Bo-Seong, 10845 Paju-si, Gyeonggi-do (KR)
(74) Representative: Viering, Jentschura & Partner mbB Patent- und Rechtsanwälte

(56) References cited:
- US-A1- 2011 240 967
- US-A1- 2013 264 551
- US-A1- 2015 311 463

## Description

### BACKGROUND OF THE INVENTION

### Field of the Invention

The present invention relates to an organic light emitting device, and more particularly, to an organic light emitting device, which provides a certain layer between a hole transport layer and an electron blocking layer so as to increase lifespan and decrease a driving voltage, and an organic light emitting display using the same.

### Discussion of the Related Art

As the information age has arrived, the field of displays visually expressing electrical information signals has rapidly developed and, in order to satisfy such a trend, various flat display devices having excellent performance, such as thin thickness, light weight and low power consumption have been researched as a substitute for a conventional cathode ray tube (CRT).

As representative examples of flat display devices, there are liquid crystal displays (LCDs), plasma display panels (PDPs), field emission displays (FEDs), and organic light emitting device (OLED) displays, etc.

Thereamong, an organic light emitting display requires no separate light source and has been considered as an application having competitiveness so as to achieve compactness of a device and good color reproduction.

The organic light emitting display includes a plurality of sub-pixels, and each sub-pixel includes an organic light emitting device (OLED: sometimes, OLED is used for 'organic light emitting diode') consisting of an anode and a cathode, and a plurality of organic layers between the anode and the cathode. The organic light emitting device emits light when a current is applied between the anode and the cathode.

At least one layer of the organic layers between the anode and the cathode is an organic light emitting layer. Holes and electrons from the anode and cathode are injected into the organic light emitting layer and are combined with each other in the organic light emitting layer, thus generating excitons. When the generated excitons are changed from an excited state to a ground state, the organic light emitting diode emits light. For example, a basic structure of the organic light emitting diode includes an anode and a cathode, and a hole injection layer, a hole transport layer, an organic light emitting layer, an electron transport layer and electron injection layer sequentially stacked from the anode, between the anode and the cathode.

Meanwhile, it is preferable that the electrons and the holes are contained in the organic light emitting diode for high emission efficiency. For this, it is suggested to provide an electron blocking layer (EBL) between the hole transport layer and the organic light emitting layer such that the electron blocking layer prevents the electrons from leaking in the organic light emitting layer when the current is applied between the anode and the cathode.

However, it is inevitable that some electrons from the organic light emitting layer escape to the hole transport layer by providing the electron blocking layer. Thus, the moved electrons is remained and cause deterioration of the hole transport layer and higher driving voltage. Accordingly, there is a difficulty to realize a certain life time.

Also, the electron blocking layer requires a broad bandgap for smoothly transporting holes and blocking electrons, but known materials used for the electron blocking layer have high LUMO (Lowest Unoccupied Molecular Orbital) and high HOMO (Highest Occupied Molecular Orbital) and thus have a narrow bandgap. Therefore, the organic light emitting device having the electron blocking layer of known material, has problems such as insufficient hole injection/transportation of holes into the light emitting layer and high driving voltage.

In US 2013/0264551 A1 a tandem white organic light emitting device having high efficiency and long lifespan by adjusting characteristics of a hole transport layer adjacent to a charge generation layer consisting of p-type and n-type charge generation layer is disclosed, the p-type charge generation layer is formed of organic materials only, and at least one organic material contained in the p-type charge generation layer has a LUMO level of -6.0 eV to -4.5 eV.

According to US 2015/0311463 A1 an organic light emitting device comprises a first and a second electrode, an organic light emitting layer disposed between the first and the second electrode, a hole injection layer adjacent to a first electrode, and a common layer disposed on the hole injection layer, wherein the common layer serves as a hole transporting layer and an electron blocking layer.

US 2011/040967 A1 describes an organic light emitting diode device, including a first electrode, a second electrode facing the first electrode, and a light emitting member disposed between the first electrode and the second electrode, the light emitting member including at least one light emitting unit. At least one of the light emitting units may include a first hole injection layer, a second hole injection layer, a hole transport layer, and an emission layer, and a difference between a HOMO energy level of the first hole injection layer and a LUMO energy level of the second hole injection layer may be smaller than about 0.5 eV.

### SUMMARY OF THE INVENTION

Accordingly, the present invention is directed to an organic light emitting device and an organic light emitting display using the same that substantially obviate one or more problems due to limitations and disadvantages of the related art.

An object of the present invention is to provide an organic light emitting device, which provides a certain layer between a hole transport layer and an electron blocking layer so as to increase lifespan and decrease a driving voltage, and an organic light emitting display using the same.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

An organic light emitting device even the structure including the electron blocking layer can simultaneously capture escaped electrons and prevent high driving voltage and increase lifespan by providing a certain layer.

To achieve these objects and other advantages and in accordance with the purpose of the invention, as embodied and broadly described herein, an organic light emitting device according to claim 1 is provided. Further embodiments are described in the dependent claims.

Even though there are holes transported from the hole transport layer into the trapping layer, the holes cannot combine with the electron having low energy level. Also, even though holes in the trapping layer partially combines with the electrons, the combined pairs in the trapping layer cannot emit due to being non-excited level and cannot cause any emission in the organic light emitting device.

Also, escaped electrons from the electron blocking layer can be captured in the trapping layer, and holes occupy the empty site in the electron blocking layer due to escaped electrons. Thus, it makes smoothly transporting holes into the light emitting layer, the trapping layer functions as a charge generation layer herein. Accordingly, a lifespan of the organic light emitting device is increased.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1 is a cross-sectional view illustrating an organic light emitting device in accordance with first embodiment of the present invention.
FIG. 2 is a band diagram of an organic light emitting device in accordance with the present invention.
FIG. 3 is a drawing to specifically show working between the hole transport layer and the electron blocking layer.
FIG. 4 is a cross-sectional view illustrating an organic light emitting device in accordance with second embodiment of the present invention.
FIG. 5 is a band diagram of an organic light emitting device in accordance with the comparative example.
FIG. 6 is a graph showing lifespans of an organic light emitting device in accordance with the experimental examples by varying the thicknesses of the trapping layer.
FIG. 7 is a graph showing driving voltages of an organic light emitting device in accordance with the experimental examples by varying the thicknesses of the trapping layer.
FIG. 8 is a cross-sectional view illustrating an organic light emitting display in accordance with the present invention.

### DETAILED DESCRIPTION OF THE INVENTION

Reference will now be made in detail to the preferred embodiments of the present invention, examples of which are illustrated in the accompanying drawings. However, the disclosure of the invention is not limited to the embodiments set forth therein and may be variously modified. It should be understood, however, that there is no intent to limit the invention to the particular forms disclosed, but on the contrary, the invention is to cover all modifications, equivalents, and alternatives falling within the spirit and scope of the invention as defined by the claims.

Shapes, sizes, rates, angles, numbers, etc. illustrated in the drawings to describe the embodiments of the present invention are exemplary and thus are not limited to the drawings. In the drawings, the same or similar elements are denoted by the same reference numerals even though they are depicted in different drawings. In the following description of the present invention, a detailed description of known functions and configurations incorporated herein will be omitted when it may make the subject matter of the present invention rather unclear. In the following description of the embodiments, the terms "including", "having", "consisting of', etc. will be interpreted as indicating the presence of other elements, unless stated otherwise, and do not exclude presence of the corresponding elements. In addition, when a singular element is stated, the element may be provided in plural, unless state otherwise.

In interpretation of elements included in the embodiments of the present invention, the elements will be interpreted as having error ranges, unless stated otherwise.

It will be understood that when positional relations between two elements are described, for example, when an element is referred to as being "on", "above", "under" or "aside" another element, intervening elements may also be present between the two elements, unless the term "just" or "directly" is used.

Further, it will be understood that when temporal relations between incidents are described, for example, the temporal order, such as "after", "subsequent to", "next" or "before", is described, the incidents may not be continuous, unless the term "just" or "directly" is used.

It will be understood that, although the terms "first", "second", etc. may be used herein to describe various elements, these elements should not be limited by these terms. Therefore, in the following description of the embodiments, an element modified by the term "first" may be the same as an element modified by the term "second", unless stated otherwise.

Respective characteristics of the embodiments of the present invention may be partially or generally combined or mixed, or be technically interlocked and driven, and the embodiments may be independently executed or be executed together in connection with each other.

Firstly, an organic light emitting device of present invention is explained.

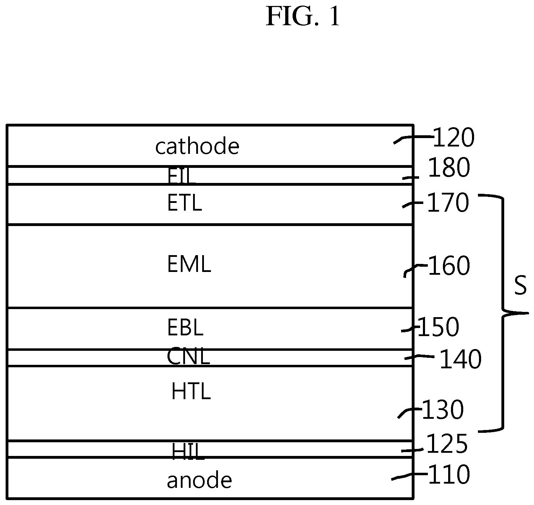

FIG. 1 is a cross-sectional view illustrating an organic light emitting device in accordance with first embodiment of the present invention.

As shown in FIG. 1, the organic light emitting device in accordance with first embodiment of the present invention includes an anode 110, a hole transport layer 130 on the anode 110, an electron blocking layer 150 on the hole transport layer 130, an organic emitting layer 160 contacting the electron blocking layer 150, and an electron transport layer 170 contacting the organic emitting layer 160, a cathode 120 on the electron transport layer 170 and a trapping layer 140 between the hole transport layer 130 and the electron blocking layer 150. A LUMO energy level of the trapping layer 140 differs from a HOMO energy level of the electron blocking layer 150 within a range of 1eV or is equal to the HOMO energy level of the electron blocking layer 150.

Also, a hole injection layer 125 is further provided between the anode 110 and the hole transport layer 130 to increase efficiency of hole injection. And an electron injection layer 180 may be further provided between the electron transport layer 170 and the anode 120 to increase efficiency of electron injection. The hole injection layer 125 and the electron injection layer 180 may be selectively provided or may same function by mixing hole injection material into the hole transport layer and electron injection material into the electron transport layer, respectively.

The trapping layer 140 between the hole transport layer 130 and the electron blocking layer 150 can trap escaped electrons from the electron blocking layer 150, and help to block the electrons from the organic emitting layer 160 with the electron blocking layer 150. Even though the electron blocking layer 150 is provided to block the electrons from the organic emitting layer 160, the electron blocking layer 150 cannot singly block total escape of electrons. The trapping layer 140 of the present invention has lower LUMO (Lowest Unoccupied Molecular Orbital) and is provided between the hole transport layer 130 and the electron blocking layer 150. Therefore, escaped electrons from the electron blocking layer 150 are captured as lower energy level in the trapping layer 140. That is, electrons escaped from the electron blocking layer 150 toward the hole transport layer 130 are captured into the trapping layer when voltages are applied to the anode 110 and the cathode 120.

The described as 'S' in FIG. 1 means essential organic stack between the anode 110 and cathode 120, and layers in the organic stack S are organic layers.

Energy band of the present invention is explained in the following description.

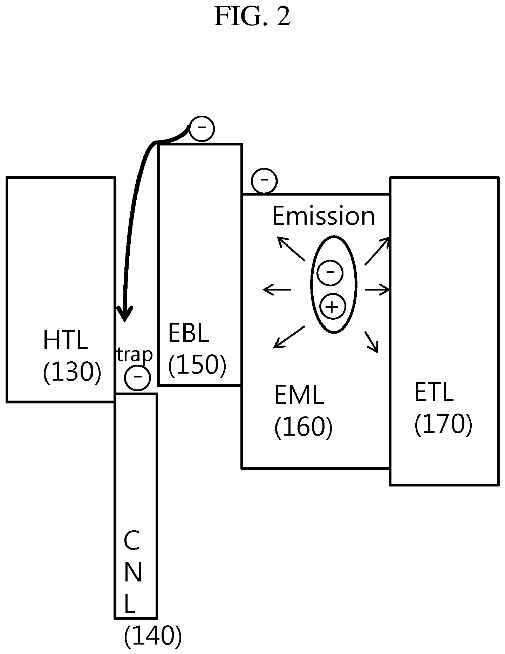

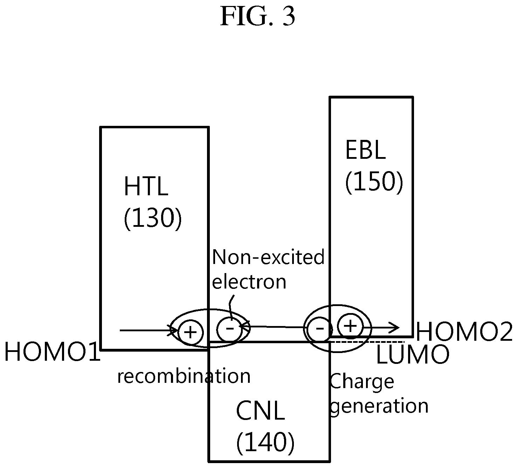

FIG. 2 is a band diagram of an organic light emitting device in accordance with the present invention and FIG. 3 is a drawing to specifically show working between the hole transport layer and the electron blocking layer.

As shown in FIG. 2, firstly, a LUMO energy level of the electron blocking layer 150 is higher than a LUMO energy level of the organic emitting layer 160, it is difficult of the electrons in the organic emitting layer 160 to escape toward hole transport layer 130.

However, if a current between the anode 110 and the cathode 120 and difference of LUMOs between the electron blocking layer 150 and the organic light emitting is within a range of 1eV, it is inevitable from the electron blocking layer 150 of the electrons to escape. In particular, the amount of escaped electrons from the electron blocking layer 150 becomes more when the current between the anode 110 and the cathode 120 becomes higher.

Also, the escaped electrons from the organic emitting layer do not contain in the electron blocking layer, can move toward adjacent layer. In the present invention, the trapping layer 140 contacts the electron transport layer 150, the escaped electrons are captured in the trapping layers 140 and thus the trapping layer 140 blocks that the electrons moves into the hole transport layer 130.

The LUMO energy level of the trapping layer 140 is equal to or similar to the HOMO energy level HOMO2 of the electron blocking layer 150. Even though there are escaped electrons from the electron blocking layer 150, energy level of the escaped electrons is lowered as a low energy level and the escaped electrons are captured into the trapping layer 140 and thus an energy level of the electrons captures in the trapping layer 140 is non-exited state. Therefore, although holes from the hole transport layer 130 and escaped electrons are partially combined in the trapping layer 140, nevertheless a non-emission state is maintained in the trapping layer 140. Although electrons of a low level are partially moved into the hole transport layer 130, the holes cannot cause deterioration of the hole transport layer and increasing a driving voltage, and hole transporting efficiency is highly maintained since holes occupies the depleted state of electrons in the organic emitting layer 160.

FIG. 3 shows the LUMO energy level LUMO of the trapping layer 140 is similar to the HOMO energy level HOMO1 of the hole transport layer 130. The LUMO energy level LUMO of the trapping layer 140 is not limited to such, the LUMO energy level LUMO of the trapping layer 140 may differ from the HOMO energy level HOMO1 of the hole transport layer 130 within a range of 1eV, and the LUMO energy level LUMO of the trapping layer 140 may differ from the HOMO energy level HOMO2 of the electron blocking layer 140 within a range of 1eV or be same to the HOMO energy level HOMO2 of the electron blocking layer 140. That is, the LUMO energy level LUMO of the trapping layer 140 may be lower than the HOMO energy level HOMO2 of the electron blocking layer 150 within 1eV or may be higher than the HOMO energy level HOMO2 of the electron blocking layer 150 within 1eV. That is, a range of the LUMO energy level LUMO of the trapping layer 140 is 'the HOMO energy level HOMO2 of the electron blocking layer 150-1eV' to 'the HOMO energy level HOMO2 of the electron blocking layer 150+1eV.' It is preferable that the LUMO energy level LUMO of the trapping layer 140 is lower than the HOMO energy level HOMO2 of the electron blocking layer 150 such that the energy level of the escaped electrons is lowered.

Herein, the LUMO energy levels, HOMO energy levels are all negative values and a LUMO energy level or a HOMO energy level located at an upper in the band diagram means a lower value as absolute value. In the description, each value of the LUMO energy levels, HOMO energy levels is compared as each substantial negative value shown in the band diagram.

Meanwhile, each energy bandgap of the hole transport layer 130, the trapping layer 140 and the electron blocking layer 150 is 2eV or more, thus the HOMO energy level of trapping layer 140 is lower than the HOMO energy level HOMO2 of the electron blocking layer 150.

The reason why the LUMO energy level LUMO of the trapping layer 140 is similar to the HOMO energy level HOMO1 of the hole transport layer 130 and the HOMO energy level HOMO 2 of the electron blocking layer 150 is to lower the energy level of the escaped electrons as a non-excited state and to move the electrons into the trapping layer 140 and block transporting electrons into the hole transport layer 130 even though there is partially escaped electrons from the electron blocking layer 150 into the hole transport layer 130.

Meanwhile, when a current is applied between an anode 110 and a cathode 120, some electrons may be combined with the holes at an interfacial between the trapping layer 140 and the hole transport layer 130. However, the electrons from and in the trapping layer 140 has a low energy level, combined hole and electron at the interfacial between the trapping layer 140 and the hole transport layer 130 has no excited level and thus combined hole and electron at the interfacial between the trapping layer 140 and the hole transport layer 130 cannot emit. And although not combined electron are partially moved to the hole transport layer 130, electrons of the low energy level cannot deteriorate the hole transport layer 130 and cannot increase the driving voltage. Also, the state that electrons escape from in the organic emitting layer 160 can be occupied with holes, holes through the hole transport layer 130, trapping layer 140 and the electron blocking layer 150 are smoothly provided into the organic emitting layer 160, thus recombination of holes and electrons in the organic emitting layer 160 is increased and it causes to climb an emission efficiency. In this case, the trapping layer 140 also functions as a charge generation.

As shown in FIG. 3, it is preferable that the LUMO energy level LUMO of the trapping layer 140 is lower than the HOMO energy level HOMO2 of the electron blocking layer 150 such that the energy level of the escaped electrons from the electron blocking layer 150 near to the HOMO energy level HOMO2 of the electron blocking layer 150 is lowered below the LUMO energy level LUMO of the trapping layer 140. In this case, the HOMO energy level HOMO 1 of the hole transport layer 130 can be slightly lower than the HOMO energy level HOMO 2 of the electron blocking layer 150 and also the HOMO energy level HOMO 1 is lower than the LUMO energy level LUMO of the trapping layer 140 as shown in FIG 3.

It is preferable that the LUMO energy level LUMO of the trapping layer 140 is between the HOMO energy level HOMO1 of the hole transport layer 130 and the HOMO energy level HOMO2 of the electron blocking layer 150 or same to the HOMO energy level HOMO1 of the hole transport layer 130 or the HOMO energy level HOMO2 of the electron blocking layer 150 in view of effectively trapping the escaped electrons and trapping holes.

For example, the HOMO energy level HOMO1 of the hole transport layer 130 is -5.6eV to -5.4eV, and the HOMO energy level HOMO2 of the electron blocking layer 150 is -5.3eV to -5.0eV. In this case, the LUMO energy level LUMO of the trapping layer 140 is -5.6eV to -5.0eV.

In the organic light emitting device, it is effective that the HOMO energy level HOMO 2 is higher than the HOMO energy level of the organic emitting layer 160 by 0.4eV. This means to solve material limit of the electron blocking layer 150 having a narrow bandgap by providing the trapping layer 140. If the electron blocking layer is in contact with the hole transport layer without a trapping layer and some electrons are escaped from the electron blocking layer, the escaped electrons is easily moved into the hole transport layer and thus the escaped electrons having a high energy level causes deterioration of the hole transport layer. On the contrary, the organic light emitting device in the present invention has the trapping layer 140 having a low LUMO energy level LUMO similar or same to the HOMO energy level HOMO2 of the electron blocking layer 150, thus the escaped electrons can be captured in the trapping layer 140, the escaped electrons are hardly moved into the hole transport layer 130. Accordingly, it makes to prevent deterioration of the hole transport layer 130 caused from the accumulation of electrons at the interfacial of the hole transport layer 130 and it is expected to increase a lifespan.

For example, material for the trapping layer 140 may be any one of HATCN, F4TCNQ and MoO3 to meet the above LUMO energy level LUMO and material for the hole transport layer 130 may be any one of N,N'-bis-(1-naphthalenyl)-N,N'-bis-phenyl-(1,1'biphenyl)-4,4'-diamine (NPB, also referred to as N,N'-bis(naphthalene-1-yl)-N,N'-bis(phenyl)benzidine (NPD)), α-NPD, BBTC, NPhen, or a derivative thereof to meet the above HOMO energy level HOMO1. Also, material for the electron blocking layer 150 may be any one of TAPC, TCTA or a derivative thereof to meet the above HOMO energy level HOMO2.

The materials for the trapping layer 140, the hole transport layer 130 and the electron blocking layer 150 are not limited to the above mentioned examples, and may be replaced with another material which can meet the energy band diagram of FIGs. 2 and 3.

Meanwhile, it is preferable that a thickness of the trapping layer 140 may be less than or equal to 1/5 times of a thickness of hole transport layer 130, or more preferable that a thickness of the trapping layer 140 is less than 1/10 times of a thickness of hole transport layer 130. Since the thickness of the trapping layer 140 is too thin to selectively function as trapping the escaped electrons, thus transportability of hole is maintained from the hole transport layer 130 to the organic emitting layer 160. For example, the thickness of the hole transport layer 130 is 100Å to 2000Å, the thickness of the electron blocking layer 150 is 30Å to 300Å. That is, the hole transport layer 130 and the electron blocking layer 150 are thicker than the thickness of the trapping layer 140 under 10Å, thus a velocity of hole transporting is maintained to ignore the trapping layer 140 between the hole transport layer 130 to the organic emitting layer 160.

It is preferable that the thickness of the trapping layer 140 is about 5Å to 10Å. If the thickness of the trapping layer 140 is smaller than 5Å, the trapping layer 140 cannot properly trap the escaped electrons, and if the thickness of the trapping layer 140 is larger than 10Å, the driving voltage may be increased. For this, it is more explained by experimental examples later in the description.

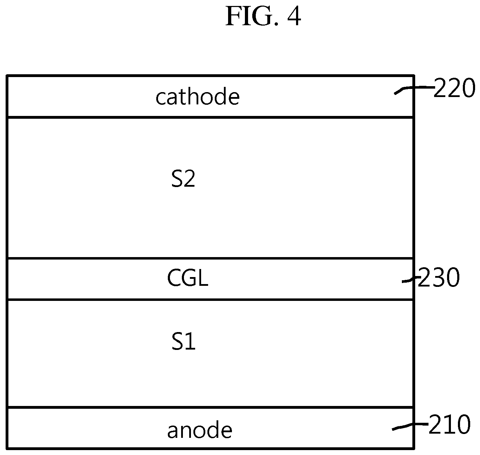

FIG. 4 is a cross-sectional view illustrating an organic light emitting device in accordance with second embodiment of the present invention.

As shown in FIG. 4, an organic light emitting device in accordance with the second embodiment of the present invention has a plurality of stacks S1, S2, ..., each stack including the hole transport layer 130the trapping layer 140, the electron blocking layer 150, the organic emitting layer 160 and the electron transport layer 170 in FIG 1. A charge generation layer 230 may be provided between stacks S1 and S2. Differently from FIG. 4, the organic light emitting device in accordance with the second embodiment of the present invention may have 3 or more stacks and each charge generation layer CGL may be positioned between two stacks.

The light emitting device in accordance with the second embodiment of the present invention has similar advantages to have the trapping layer 140 between thin hole transport layer 130 and the electron blocking layer 150 in the stack S1, S2..., such as the light emitting device in accordance with the first embodiment of the present invention.

Hereinafter, referring Drawings and Examples, comparative example and experimental examples are compared.

The comparative example corresponds to the structure except the trapping layer 140 in FIG 1. The comparative example is understood by FIG. 4.

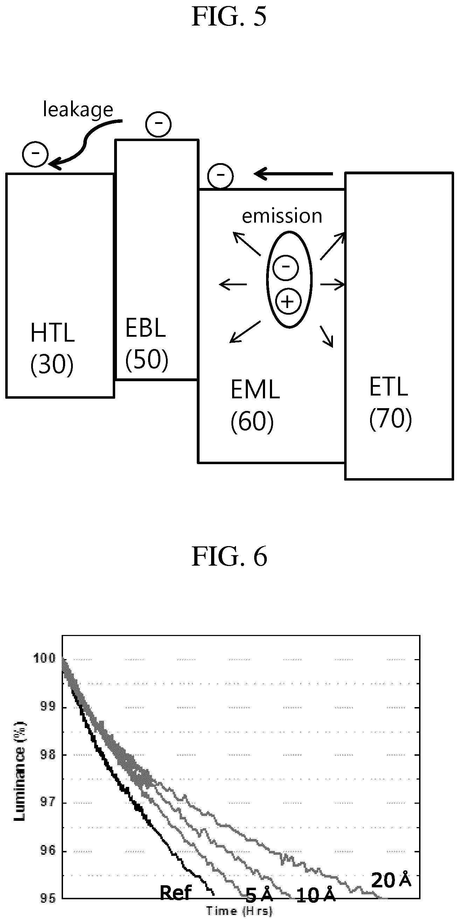

FIG. 5 is a band diagram of an organic light emitting device in accordance with the comparative example.

As shown in FIG. 5, the organic light emitting device in accordance with the comparative example, there are a hole transport layer 30, an electron blocking layer 50, an organic emitting layer 60 and an electron transport layer 70 between an anode and a cathode.

In the comparative example, although the electron blocking layer 50 is positioned adjacent to the organic emitting layer 60, electrons escaped from the organic emitting layer 60 may be disposed between the hole transport layer 30 and the electron blocking layer 50, and escaped electrons can be easily excited and can be combined with holes to cause leakage of emission in the hole transport layer 30 in addition to the organic emitting layer 60. Also, some moved electrons into the hole transport layer 30 deteriorate the hole transport layer 30, it causes to lower a lifespan of the organic light emitting device of the comparative example.

It is ideal to use a material to have a broad energy bandgap for the electron blocking layer 50, which has a high LUMO energy level and a low LUMO energy level, but it is hardly to find the material for the electron blocking layer 50. Substantially, the energy bandgap of the electron blocking layer 50 is 2eV to 3eV and it is difficult to complex a material having a broad energy bandgap for the electron blocking layer. The present invention uses structural change in the organic light emitting device by introducing the trapping layer 140 between the hole transport layer 130 and the electron blocking layer 150 to overcome material limit of the electron blocking layer.

In the comparative example and experimental examples, characteristic between time-luminance and driving voltages are compared by without a trapping layer or varying the thicknesses of the trapping layer as 5Å, 10Å, and 20Å.

FIG. 6 is a graph showing lifespans of an organic light emitting device in accordance with the experimental examples by varying the thicknesses of the trapping layer.

As shown in FIG. 6, lifespans are increased in all experimental examples and the lifespan is more increased when the thickness of the trapping layer 140 becomes thicker. On the contrary, a lifespan in the comparative example having no trapping layer is less than the lifespan even in the experimental example of the thickness 5Å of the trapping layer 140 being least experimental example.

The graph illustrates a time that a luminance is changed from an initial state to 95% luminance.

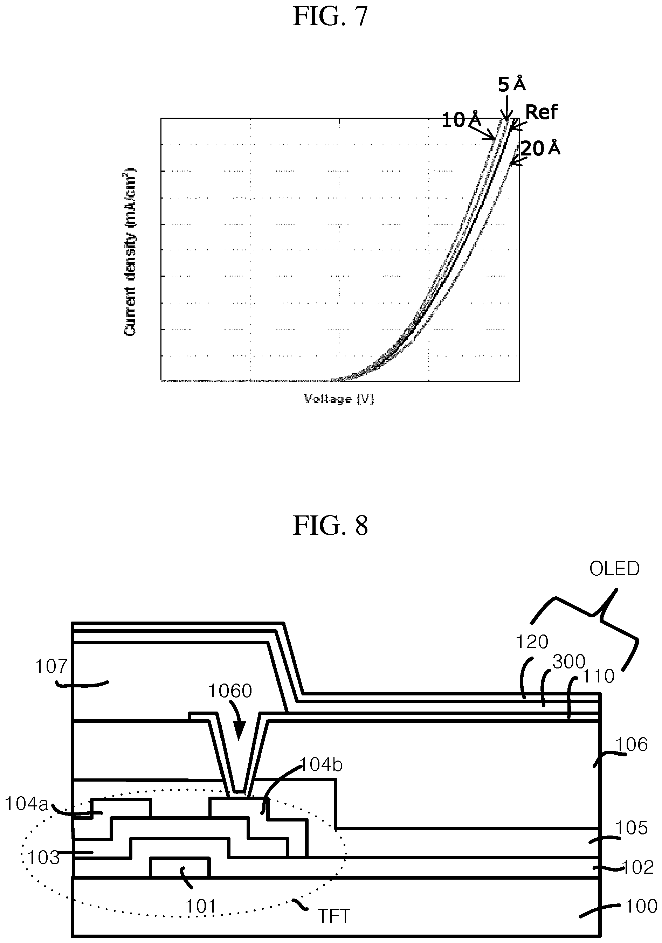

FIG. 7 is a graph showing driving voltages of an organic light emitting device in accordance with the experimental examples by varying the thicknesses of the trapping layer.

As shown in FIG. 7, in the cases of providing the trapping layer 140 having the thickness as 5Å and 10Å, the driving voltages are lowered than that of the comparative example by 0.1V or more. However, the case of providing the trapping layer 140 having the thickness as 20Å, the driving voltage is rather increased than that of the comparative example.

That is, in order to together increase the lifespan and lower the driving voltage, it is preferable that the thickness of the trapping layer is in a range of 5Å to 10Å.

Meanwhile, the organic light emitting display of the present invention applies the organic light emitting device of the present invention provided at each sub-pixel.

FIG. 8 is a cross-sectional view illustrating an organic light emitting display in accordance with the present invention.

As exemplarily shown in FIG. 8, the organic light emitting display in accordance with the present invention includes a substrate 100 including a plurality of sub-pixels, thin film transistors (TFTs) of the respective sub-pixels being provided on the substrate 100, and organic light emitting devices (OLED) having anodes 110 and cathodes 120. Here, the anode 110 or the cathode 120 of each organic light emitting device is connected to each TFT. Although FIG. 8 illustrates one sub-pixel, sub-pixels having the same shape are substantially arranged in a matrix on the substrate 100.

Here, the thin film transistor includes a gate electrode 101 provided in a designated region on the substrate 100, a gate insulating film 102 formed on the substrate 100 so as to cover the gate electrode 101, a semiconductor layer 103 formed on the gate insulating film 102 so as to correspond to the gate electrode 101, and a source electrode 104a and a drain electrode 104b formed at both sides of the semiconductor layer 103.

Further, an inorganic protective film 105 and an organic protective film 106 are sequentially provided to cover the source electrode 104a and the drain electrode 104b, and the anode 110 or the cathode 120 is connected to the drain electrode 104b via a contact hole 1060 formed through the organic protective film 106 and the inorganic protective film 105 to expose a part of the drain electrode 104b.

For example, if the anode 110 is connected to the drain electrode 104b, an organic stack 300, in which a hole transport layer (HTL) 130, a trapping layer (CNL) 140, an electron blocking layer (EBL) 150, an organic emitting layer (EML) 160 and an electron transport layer (ETL) 170 are sequentially deposited, is formed on the anode 110, and the cathode 120 is provided on the organic stack 300, similarly as for the stack S shown in FIG 1. As circumstances require, the organic stack 300 may be replaced with the stack structure shown in FIG. 4.

On the other hand, if the cathode 120 is connected to the drain electrode 104b, an organic stack, in which the above-described elements are provided in reverse order, is provided. That is, an electron transport layer ETL, an organic emitting layer EML, an electron blocking layer EBL, a trapping layer CNL, and a hole transport layer HTL are sequentially deposited on the cathode, and then an anode is formed on the hole transport layer HTL.

A hole injection layer is further provided between the anode 110 and a hole transport layer (HTL) 130, and an electron injection layer may be further provided between the electron transport layer (ETL) 170 and the cathode 120.

Further, although this figure illustrates a bank 107 provided to define an emission zone, the bank 107 may be omitted and the emission zone may be defined by other structures or the organic stack and the cathode 120 may be provided in common in all sub-pixels and colors of the sub-pixels may be discriminated by color filters.

Moreover, although FIG. 8 illustrates the organic light emitting device in accordance with the embodiment shown in FIG 1, the disclosure is not limited thereto and the organic light emitting device in accordance with the embodiment shown in FIG. 4, in which a plurality of stacks is provided between an anode and a cathode, may be provided.

The above-described organic light emitting display may achieve color expression by emitting different colors of light through the organic emitting layers of the respective sub-pixels, or achieve color expression by adding a color filter layer to a light emitting portion of a common organic emitting layer.

Such an organic light emitting display including the above-described organic light emitting device may have the same effects as the above-described organic light emitting device.

As apparent from the above description, an organic light emitting device and an organic light emitting display using the same in accordance with one embodiment of the present invention have effects below.

First, the present invention provides a trapping layer between the hole transport layer and the electron blocking layer and uses the material for the trapping layer having a low LUMO energy level similar to the HOMO levels of the hole transport layer and the electron blocking layer, thus the energy level of electrons into the trapping layer is lowered to a ground state and it can block that the electrons escaped from the electron blocking layer is excited. Also, it prevents deterioration of the hole transport layer and prevent increasing the driving voltage.

Also, when the holes are transported from the hole transport layer to the organic emitting layer, the holes cannot react the electrons of a low energy level in the trapping layer, thus it blocks leakage of emission outside of the organic emitting layer.

Further, escaped electrons from the electron blocking layer can be captured in the trapping layer and the empty sites of the electron blocking layer and the organic emitting layer addition due to electrons' escaping is occupied with holes and thus it helps that holes are easily transported from the hole transport layer into the organic emitting layer. In this case, the trapping layer functions as a charge generation layer, and helps increase of a lifespan of the organic light emitting device or the organic light emitting display.

## Claims

1. An organic light emitting device comprising:
an anode (110);
a hole injection layer (125) on the anode (110);
a hole transport layer (130) on the hole injection layer (125);
an electron blocking layer (150) on the hole transport layer (130), an organic emitting layer (160) contacting the electron blocking layer (150), and an electron transport layer (170) contacting the organic emitting layer (160);
a cathode (120) on the electron transport layer (170); and
a trapping layer (140) between the hole transport layer (130) and the electron blocking layer (150),
wherein the trapping layer(140) contacts the hole transport layer (130) and the electron blocking layer (150) at opposite surfaces,
wherein a LUMO energy level of a material for the trapping layer (140) differs from a HOMO energy level of a material for the electron blocking layer (150) within a range of 1eV or is equal to a HOMO energy level of the material for the electron blocking layer (150),
and a LUMO energy level of the material for the electron blocking layer (150) is higher than a LUMO energy level of a material for the organic emitting layer (160),
wherein the LUMO energy level of the material for the trapping layer (140) differs from a HOMO energy level of a material for the hole transport layer (130) within a range of 1eV or is equal to the HOMO energy level of the material for the hole transport layer (130).

2. The organic light emitting device according to claim 1, wherein the LUMO energy level of the material for the trapping layer (140) is lower than the HOMO energy level of the material for the electron blocking layer (150).

3. The organic light emitting device according to claim 1, wherein the LUMO energy level of the material for the trapping layer (140) is between the HOMO energy level of the material for the hole transport layer (130) and the electron blocking layer (150) or equal to the HOMO energy level of the material for the hole transport layer (130) and of the material for the electron blocking layer (150).

4. The organic light emitting device according to claim 3, wherein the HOMO energy level of the material for the electron blocking layer (150) is higher than a HOMO energy level of the material for the organic emitting layer (160) by 0.4eV.

5. The organic light emitting device according to any one of claims 1 to 4, wherein a thickness of the trapping layer (140) is less than or equal to 1/5 times of a thickness of the hole transport layer (130).

6. The organic light emitting device according to claim 5, wherein the thickness of the trapping layer (140) is 5Å to 10Å.

7. The organic light emitting device according to any one of claims 1 to 6, wherein electrons escaped from the electron blocking layer (150) toward the hole transport layer (130) are captured into the trapping layer (140) when voltages are applied to the anode (110) and the cathode (120).

8. An organic light emitting display comprising:
a substrate (100) having a plurality of subpixels;
each subpixel of the plurality of subpixels comprising a thin-film transistor (TFT) and an organic light emitting device (OLED) according to any one of claims 1 to 7,
wherein the thin-film transistor is connected to one of the anode (110) and the cathode (120) of the organic light emitting device.

## Patentansprüche

1. Eine organische Licht emittierende Vorrichtung, aufweisend:
eine Anode (110);
eine Lochinjektionsschicht (125) auf der Anode (110);
eine Lochtransportschicht (130) auf der Lochinjektionsschicht (125);
eine Elektronenblockierschicht (150) auf der Lochtransportschicht (130), eine organische emittierende Schicht (160), die die Elektronenblockierschicht (150) kontaktiert, und eine Elektronentransportschicht (170), die die organische emittierende Schicht (160) kontaktiert;
eine Kathode (120) auf der Elektronentransportschicht (170); und
eine Einfangschicht (140) zwischen der Lochtransportschicht (130) und der Elektronenblockierschicht (150),
wobei die Einfangschicht (140) die Lochtransportschicht (130) und die Elektronenblockierschicht (150) an gegenüberliegenden Oberflächen kontaktiert, wobei sich ein LUMO-Energieniveau eines Materials für die Einfangschicht (140) von einem HOMO-Energieniveau eines Materials für die Elektronenblockierschicht (150) innerhalb eines Bereichs von 1 eV unterscheidet oder gleich einem HOMO-Energieniveau des Materials für die Elektronenblockierschicht (150) ist,
und ein LUMO-Energieniveau des Materials für die Elektronenblockierschicht (150) höher ist als ein LUMO-Energieniveau eines Materials für die organische emittierende Schicht (160),
wobei sich das LUMO-Energieniveau des Materials für die Einfangschicht (140) von einem HOMO-Energieniveau eines Materials für die Lochtransportschicht (130) innerhalb eines Bereichs von 1 eV unterscheidet oder gleich dem HOMO-Energieniveau des Materials für die Lochtransportschicht (130) ist.

2. Organische Licht emittierende Vorrichtung nach Anspruch 1, wobei das LUMO-Energieniveau des Materials für die Einfangschicht (140) niedriger ist als das HOMO-Energieniveau des Materials für die Elektronenblockierschicht (150).

3. Organische Licht emittierende Vorrichtung nach Anspruch 1, wobei das LUMO-Energieniveau des Materials für die Einfangschicht (140) zwischen dem HOMO-Energieniveau des Materials für die Lochtransportschicht (130) und der Elektronenblockierschicht (150) liegt oder gleich dem HOMO-Energieniveau des Materials für die Lochtransportschicht (130) und des Materials für die Elektronenblockierschicht (150) ist.

4. Organische Licht emittierende Vorrichtung nach Anspruch 3, wobei das HOMO-Energieniveau des Materials für die Elektronenblockierschicht (150) um 0,4 eV höher ist als ein HOMO-Energieniveau des Materials für die organische emittierende Schicht (160).

5. Organische Licht emittierende Vorrichtung nach einem der Ansprüche 1 bis 4, wobei eine Dicke der Einfangschicht (140) kleiner oder gleich dem 1/5-fachen einer Dicke der Lochtransportschicht (130) ist.

6. Organische Licht emittierende Vorrichtung nach Anspruch 5, wobei die Dicke der Einfangschicht (140) 5 Ä bis 10 Ä beträgt

7. Organische Licht emittierende Vorrichtung nach einem der Ansprüche 1 bis 6, wobei Elektronen, die von der Elektronenblockierschicht (150) in Richtung der Lochtransportschicht (130) entweichen, in die Einfangschicht (140) eingefangen werden, wenn Spannungen an die Anode (110) und die Kathode (120) angelegt werden.

8. Organisches Licht emittierendes Display, aufweisend:
ein Substrat (100) eine Vielzahl von Subpixeln aufweisend;
jedes Subpixel der Vielzahl von Subpixeln einen Dünnschichttransistor (TFT) und eine organische Licht emittierende Vorrichtung (OLED) gemäß einem der Ansprüche 1 bis 7 aufweisend,
wobei der Dünnschichttransistor mit einer der Anode (110) und der Kathode (120) der organischen Licht emittierenden Vorrichtung verbunden ist.

## Revendications

1. Dispositif électroluminescent organique, comprenant :
une anode (110),
une couche d'injection de trous (125) sur l'anode (110),
une couche de transport de trous (130) sur la couche d'injection de trous (125),
une couche de blocage d'électrons (150) sur la couche de transport de trous (130), une couche d'émission organique (160) contactant la couche de blocage d'électrons (150), et une couche de transport d'électrons (170) contactant la couche d'émission organique (160),
une cathode (120) sur la couche de transport d'électrons (170), et
une couche de piégeage (140) entre la couche de transport de trous (130) et la couche de blocage d'électrons (150),
dans lequel la couche de piégeage (140) contacte la couche de transport de trous (130) et la couche de blocage d'électrons (150) sur des surfaces opposées,
dans lequel un niveau d'énergie LUMO d'un matériau pour la couche de piégeage (140) diffère d'un niveau d'énergie HOMO d'un matériau pour la couche de blocage d'électrons (150) dans une plage de 1eV ou est égal à un niveau d'énergie HOMO du matériau pour la couche de blocage d'électrons (150),
et un niveau d'énergie LUMO du matériau pour la couche de blocage d'électrons (150) est supérieur à un niveau d'énergie LUMO d'un matériau pour la couche d'émission organique (160),
dans lequel le niveau d'énergie LUMO du matériau pour la couche de piégeage (140) diffère d'un niveau d'énergie HOMO d'un matériau pour la couche de transport de trous (130) dans une plage de 1eV ou est égal au niveau d'énergie HOMO du matériau pour la couche de transport de trous (130).

2. Dispositif électroluminescent organique selon la revendication 1, dans lequel le niveau d'énergie LUMO du matériau pour la couche de piégeage (140) est inférieur au niveau d'énergie HOMO du matériau pour la couche de blocage d'électrons (150).

3. Dispositif électroluminescent organique selon la revendication 1, dans lequel le niveau d'énergie LUMO du matériau pour la couche de piégeage (140) est entre le niveau d'énergie HOMO du matériau pour la couche de transport de trous (130) et la couche de blocage d'électrons (150) ou égal au niveau d'énergie HOMO du matériau pour la couche de transport de trous (130) et du matériau pour la couche de blocage d'électrons (150).

4. Dispositif électroluminescent organique selon la revendication 3, dans lequel le niveau d'énergie HOMO du matériau pour la couche de blocage d'électrons (150) est supérieur de 0,4eV à un niveau d'énergie HOMO du matériau pour la couche d'émission organique (160).

5. Dispositif électroluminescent organique selon l'une quelconque des revendications 1 à 4, dans lequel une épaisseur de la couche de piégeage (140) est inférieure ou égale à 1/5 fois une épaisseur de la couche de transport de trous (130).

6. Dispositif électroluminescent organique selon la revendication 5, dans lequel l'épaisseur de la couche de piégeage (140) est de 5Â à 10Â.

7. Dispositif électroluminescent organique selon l'une quelconque des revendications 1 à 6, dans lequel des électrons échappés de la couche de blocage d'électrons (150) vers la couche de transport de trous (130) sont capturés dans la couche de piégeage (140) lorsque des tensions sont appliquées à l'anode (110) et à la cathode (120).

8. Affichage électroluminescent organique, comprenant :
un substrat (100) présentant une pluralité de sous-pixels,
chaque sous-pixel de la pluralité de sous-pixels comprenant un transistor à couche mince (TFT) et un dispositif électroluminescent organique (OLED) selon l'une quelconque des revendications 1 à 7,
dans lequel le transistor à couche mince est connecté à l'une de l'anode (110) et de la cathode (120) du dispositif électroluminescent organique.
